# EUROPÄISCHE PATENTSCHRIFT

(11) **EP 1 469 710 B1**
(45) Veröffentlichungstag und Bekanntmachung des Hinweises auf die Patenterteilung: **05.09.2012**
(21) Anmeldenummer: 04002650.2
(22) Anmeldetag: 06.02.2004
(51) Int. Cl.: H05K 1/14, H05K 7/14

(54) **Bauelementeträger und Verfahren zu dessen Herstellung**
Component support and process for manufacturing the same
Support de composants et son procédé de fabrication

(30) Priorität: 14.04.2003 DE 10317095
(43) Veröffentlichungstag der Anmeldung: 20.10.2004
(73) Patentinhaber: ROBERT BOSCH GMBH, 70442 Stuttgart (DE)
(72) Erfinder: Uhland, Thomas, 74397 Pfaffenhofen-Weiler (DE); Schinzel, Ralf, 71672 Marbach Am Neckar (DE); Degirmenci, Ibrahim, 71665 Vaihingen (DE)

(56) Entgegenhaltungen:
- DE-A1- 3 805 121
- DE-A1- 4 405 578
- DE-A1- 19 756 345
- FR-A- 2 582 898
- US-A- 5 880 935
- US-A1- 2002 189 089
- US-A1- 2003 035 280
- PATENT ABSTRACTS OF JAPAN Bd. 013, Nr. 416 (E-821), 14. September 1989 (1989-09-14) & JP 01 154592 A (NEC CORP), 16. Juni 1989 (1989-06-16)

## Beschreibung

### STAND DER TECHNIK

Die Erfindung betrifft einen Bauelementeträger sowie ein Verfahren zur Herstellung eines derartigen Bauelementeträgers.

Bisher ist es bei der Herstellung von Bauelementeträgem üblich, nach dem Prinzip der Stanzgittertechnik vorzugehen. Zuerst wird das gebogene Stanzgitter mit Kunststoff umspritzt. Anschließend werden die Bauteile mit dem umspritzten Stanzgitter durch Widerstandsschweißen verbunden.

Als nachteilig ist an dieser Technik anzusehen, dass sie hohe Werkzeug- und Anlagekosten bedingt, wobei bei Änderungen das gesamte Stanzgitter sowie die Kunststoffumspritzung neu konfiguriert werden muss. Ungünstig ist auch, dass beim Schweißen die Verbindung von Bauelement zum Stanzgitter seriell erfolgt, d.h., dass jede Schweißung separat erfolgt und dadurch lange Taktzeiten vorhanden sind. Die Baugröße der nach den Stanzgitterverfahren hergestellten Bauelementeträger ist technisch bedingt nur begrenzt reduzierbar, wodurch auch das Schüttelverhalten bzw. die Schütteltauglichkeit des fertig gestellten Bauelementeträgers verbesserungsbedürftig ist.

Ungünstig ist weiterhin, dass EMV-Maßnahmen nicht oder nur mit großem Aufwand realisierbar sind und dass die Layout-Gestaltungsmöglichkeiten der Schaltung auf dem Bauelementträger begrenzt und ebenfalls verbesserungsbedürftig sind.

Patentanmeldungen US 2002/0189089 und FR 2582898 werden zur Abgrenzung des Anspruchs 1 verwendet, und zeigen herkömmliche Verbindungen zweier Schaltungsträger.

Mit der Erfindung soll ein Bauelementeträger und ein Verfahren zu dessen Herstellung verfügbar gemacht werden, bei dem die Vorzüge einer vergrößerten Layout-Gestaltungsmöglichkeit mit denen eines verbesserten Schüttelverhaltens kombiniert sind.

Erfindungsgemäß wird diese Aufgabe durch einen Bauelementeträger mit dem Merkmal des Anspruchs 1 gelöst.

Bevorzugte Merkmale, die die Erfindung vorteilhaft weiterbilden, sind den nachgeordneten Ansprüchen 2 bis 8 zu entnehmen.

Verfahrensseitig wird diese Aufgabe durch das Verfahren gemäß Anspruch 9 gelöst.

Aufgrund der erfindungsgemäßen Ausgestaltung des Bauelementeträgers ist es vorteilhaft möglich, durch Aufteilung des Schaltungsträgers in mehrere Abschnitte auch eine lagenförmige Anordnung in mehreren Ebenen zu realisieren, während mit einem Stanzgitter nur eine Ebene zum Layouten vorhanden ist. Hierdurch werden die Möglichkeiten der Layout-Gestaltung der Schaltung erheblich vergrößert.

Der erfindungsgemäße Bauelementeträger ist wesentlich unempfindlicher gegenüber Änderungen von Bauteil und Layout, weil nur eine Änderung des Schaltungs-Layouts erforderlich ist, während bei der Stanzgittertechnik eine komplette Umkonstruktion von Stanzgitter und Umspritzung nötig ist.

Durch die vorgesehene Verwendung von Schaltungsträgern statt Stanzgitter wird auch eine Verbesserung des EMV-Verhaltens ermöglicht, da an EMV-kritischen Schaltungsbereichen kurze Leitungsführungen vorgesehen werden können und EMV-verbessernde Schaltungsmaßnahmen, wie z.B. EMV-Kondensatoren o.ä., einsetzbar sind.

In vorteilhafter Weise ermöglicht die erfindungsgemäße Ausbildung des Bauelementeträgers eine Auslagerung von Schaltungsteilen auf verschiedene Schaltungsträger, wodurch auch ein Platzgewinn auf einem Hauptschaltungsträger bzw. einer Hauptleiterplatte möglich ist, was sich auch in einer Kostenreduktion niederschlägt.

Ein weiterer Vorteil ist, dass sich der Bauelementeträger in reduzierter Baugröße herstellen lässt, da Schweißtabuzonen entfallen. Die Verringerung der Baugröße ist günstig für eine Verbesserung des Schüttelverhaltens.

Aufgrund des Entfalls von Schweißtabuzonen und der Möglichkeit, doppelseitig bestückte Schaltungsträger bzw. zwei erste Schaltungsträger in Bezug zur Aufnahmeeinrichtung vorzusehen, lässt sich die Verpackungsdichte vorteilhaft erhöhen, was wiederum der Verkleinerung der Baugröße zugute kommt.

Ein weiterer Vorteil bei der Herstellung des erfindungsgemäßen Bauelementeträgers ist die erzielbare Taktzeitverringerung, das Schaltungsträger und bedrahtete Bauelemente und Sonderbauteile in einem Vorgang zum Beispiel durch partielles Löten miteinander verbunden werden können.

Bei dem erfindungsgemäßen Bauelementeträger sind nach einer bevorzugten Ausgestaltung der Erfindung der erste und/oder der zweite Schaltungsträger mit einer Leiterplatte, einer Flexfolie oder dergleichen ohne das herkömmliche Stanzgitter gebildet.

Gemäß einer bevorzugten weiteren Ausgestaltung der Erfindung ist die Ladeverbindung mit geringer Steifigkeit mit einem Pin, vorzugsweise einem Stanzgitter-Pin gebildet, der eine Geometrie zur mechanischen Entlastung aufweist.

Nachfolgend wird die Erfindung anhand der beigefügten Zeichnungen näher erläutert. Es zeigen:
- Figur 1: eine Explosionsansicht eines Ausführungsbeispiels eines erfindungsgemäßen Bauelementeträgers;
- Figur 2: eine perspektivische Ansicht des Bauelementeträgers von Figur 1 schräg von unten;
- Figur 3: eine vergrößerte Detaildarstellung der Befestigung eines verdrahteten Bauelements auf dem ersten Schaltungsträger;
- Figur 4: den in Figur 1 und 2 gezeigten Bauelementeträger nach Fertigstellung; und
- Figur 5: eine vergrößerte Darstellung einer Leiterverbindung mit geringer Steifigkeit und mechanischer Entlastung.

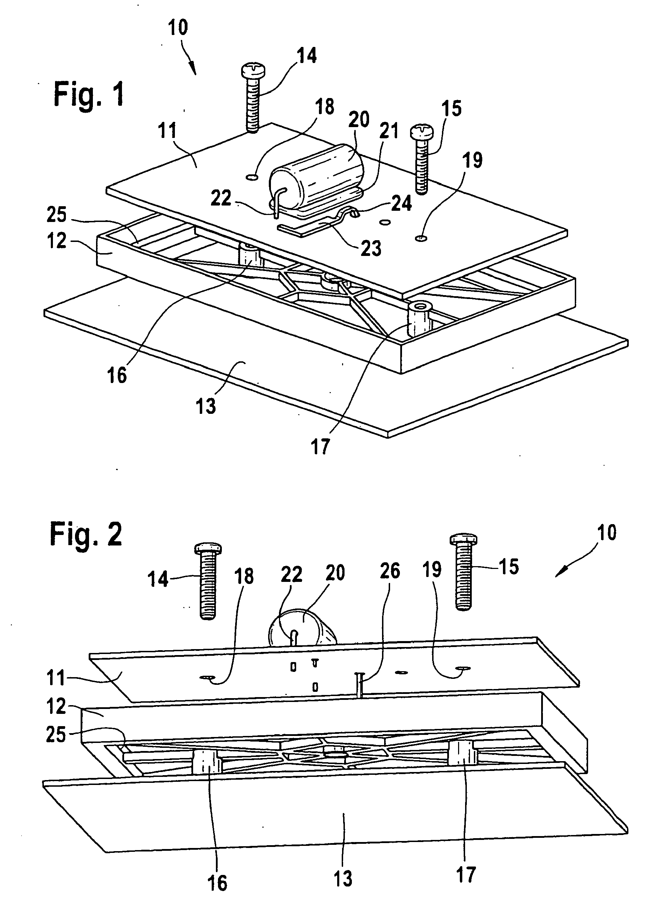

In Figur 1 ist ein Ausführungsbeispiel eines Bauelementeträgers 10 dargestellt, der aus einem ersten Schaltungsträger 11, einer raumförmigen Aufnahmeeinrichtung 12 und einem zweiten Schaltungsträger 13 besteht. Mit 14 und 15 sind Schrauben dargestellt, mit denen der erste Schaltungsträger 11 in entsprechend vorgesehene Schraubaufnahmen 16 bzw. 17 durch Löcher 18 bzw. 19 in dem ersten Schaltungsträger 11 zur Befestigung des Schaltungsträgers 11 an der rahmenförmigen Aufnahmeeinrichtung 12 einschraubbar sind.

Statt der Befestigung mit Schrauben 14 und 15 kann auch eine vorzugsweise lösbare Verrastung in der Aufnahmeeinrichtung 12 oder eine Verklebung des Schaltungsträgers 11 in der Aufnahmeinrichtung 12 vorgesehen sein. Die Aufnahmeeinrichtung 12 ist an dem zweiten Schaltungsträger 13 beispielsweise durch Verklebung befestigt. Alternativ kann sie auch verschraubt oder/ und geklebt werden.

Die als rahmenförmige Halterung ausgebildete Aufnahmeeinrichtung 12 besteht aus Kunststoff, könnte jedoch auch aus Druckguss, Blech oder dergleichen ausgeführt werden.

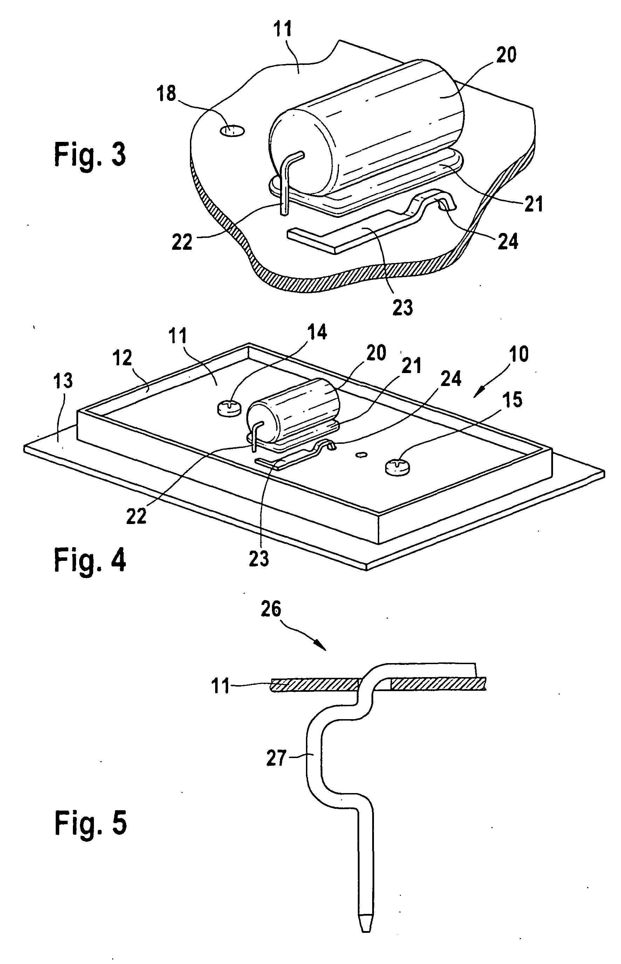

Beispielhaft ist vergrößert in Figur 3 die Befestigung eines bedrahteten Bauelementes 20 auf dem ersten Schaltungsträger 11 mittels eines großflächigen aufgebrachten Klebers 21 dargestellt. Das Bauelement 20 besitzt beiderseits oder auch nur einseitig eine Bedrahtung 22, die üblicherweise durch eine Bohrung im Schaltungsträger 11 zum späteren Verlöten durchgeführt sind.

Neben dem Bauelement 20 ist in Figur 3 weiterhin ein Blechstanzteil 23 dargestellt, das auf dem ersten Schaltungsträger 11 aufliegt und als mechanische Entlastung einen bogenförmigen Abschnitt 24 aufweist, der in einen senkrechten Abschnitt übergeht, der durch eine nicht-dargestellte Bohrung des ersten Schaltungsträgers 11 tritt und als Leiterverbindung zu dem zweiten Schaltungsträger 13 ausgebildet ist. Durch die mechanische Entlastung wird eine verringerte Steifigkeit der Leitungsverbindung erzielt.

Figur 4 zeigt den zusammengebauten Bauelementeträger 10 in einer schrägen Draufsicht, wobei erkennbar ist, dass der erste Schaltungsträger, der als Leiterplatte ausgebildet ist, in der rechteckigen raumförmigen Halterung 12 aufgenommen ist und sicher an eine Anlageschulter 25 anliegt.

Die rahmenförmige Halterung 12 kann auch dahingehend modifiziert ausgebildet sein, dass sie zur beiderseitigen Aufnahme von Schaltungsträgern eingesetzt werden kann.

Figur 5 zeigt ein Ausführungsbeispiel einer Leiterverbindung 26, bei der ein mechanischer Entlastungsabschnitt 27 in dem Bereich zwischen erstem und zweitem Schaltungsträger angeordnet ist.

Bei dem Verfahren zur Herstellung eines derartigen Bauelementeträgers 10 wird in einem ersten Schritt zunächst eine elektrische Schaltung auf wenigstens zwei Schaltungsträger, vorzugsweise Leiterplatten verteilt, wobei ein erster Schaltungsträger bzw. eine erste Leiterplatte vorzugsweise für das Bestücken mit bedrahteten Bauelementen und Sonderbauteilen und ein zweiter Schaltungsträger keine oder nur wenige bedrahteten Bauelemente und Sonderbauteile, sondern SMD-Bauteile, wie ICs oder dergleichen aufweist. Es können auch bedarfsweise mehr als ein erster oder zweiter Schaltungsträger vorgesehen sein. Ferner können auf der ersten Leiterplatte auch SMD-Bauteile vorgesehen sein.

Anschließend wird der oder werden die ersten Schaltungsträger, wie vorgesehen, mit bedrahteten Bauelementen und Sonderbauteilen bestückt und die Bauteile dann durch Löten elektrisch kontaktiert.

Hieran schließt sich dann das Befestigen des oder der ersten Schaltungsträger an eine Aufnahmeeinrichtung an, die in geeigneter Weise gebildet sein kann, beispielsweise als Halter oder bevorzugt als rahmenförmige Halterung.

Die Aufnahmeeinrichtung wird anschließend auf dem zweiten Schaltungsträger befestigt und dann wird der erste Schaltungsträger elektrisch mit dem zweiten Schaltungsträger über wenigstens einen Leiter geringer Steifigkeit verbunden.

### Bauelementeträger und Verfahren zu dessen Herstellung

### BEZUGSZEICHENLISTE:

| | |
|---|---|
| 10 | Bauelementeträger |
| 11 | erster Schaltungsträger |
| 12 | Aufnahmeeinrichtung |
| 13 | zweiter Schaltungsträger |
| 14, 15 | Schrauben |
| 16, 17 | Schraubaufnahmen |
| 18, 19 | Löcher |
| 20 | Bedrahtetes elektrisches Bauelement |
| 21 | Kleber |
| 22 | Bedrahtung |
| 23 | Blechstanzteil |
| 24 | Entlastungsabschnitt |
| 25 | Anlageschulter |
| 26 | Leitungsverbindung |
| 27 | Entlastungsabschnitt |

## Patentansprüche

1. Bauelementeträger (10), bestehend aus
wenigstens einem ersten Schaltungsträger (11), der mit bedrahteten elektrischen Bauelementen (20) und Sonderbauteilen bestückt ist,
einer Einrichtung (12) zur Aufnahme wenigstens eines ersten Schaltungsträgers (11); und aus
einem von dem ersten Schaltungsträger beabstandeten zweiten Schaltungsträger (13) ohne bzw. mit nur wenigen bedrahteten elektrischen Bauelementen und Sonderbauteile,
wobei der zweite Schaltungsträger (13) an jedem ersten Schaltungsträger (11) elektrisch mittels wenigstens einer Leitungsverbindung (26) mit geringer Steifigkeit angeschlossen ist, **dadurch gekennzeichnet,**
**dass** die Leitungsverbindung (26) mit geringer Steifigkeit mit wenigstens einem Pin, vorzugsweise einem Stanzgitterpin gebildet ist, der eine Geometrie zur mechanischen Entlastung aufweist.

2. Bauelementeträger nach Anspruch 1, **dadurch gekennzeichnet, dass** der erste und/oder der zweite Schaltungsträger eine Leiterplatte, Flexfolie oder dergleichen aufweist.

3. Bauelementeträger nach Anspruch 1 oder 2, **dadurch gekennzeichnet, dass** auf jedem ersten Schaltungsträger die bedrahteten Bauelemente (20) und die Sonder-bauteile mittels eines Klebers (21) und/oder eines separaten Halters befestigt sind.

4. Bauelementeträger nach einem der vorangehenden Ansprüche, **dadurch gekennzeichnet, dass** an der Aufnahmeeinrichtung (12) zwei erste Schaltungsträger (11) angeordnet sind.

5. Bauelementeträger nach einem der vorangehenden Ansprüche, **dadurch gekennzeichnet, dass** die Aufnahmeeinrichtung (12) als rahmenförmige oder flächige Halterung ausgebildet ist.

6. Bauelementeträger nach einem der vorangehenden Ansprüche, **dadurch gekennzeichnet, dass** die Aufnahmeeinrichtung (12) aus Kunststoff, Guss oder Blech gebildet ist.

7. Bauelementeträger nach einem der vorangehenden Ansprüche, **dadurch gekennzeichnet, dass** an jedem ersten Schaltungsträger (11) wenigstens eine Anschlussstelle für die Leitungsverbindung (26) gebildet ist.

8. Bauelementeträger nach einem der vorangehenden Ansprüche, **dadurch gekennzeichnet, dass** die Leitungsverbindung (26) mit Geometrie zur mechanischen Entlastung einen mechanischen Entlastungsabschnitt (27) in dem Bereich zwischen erstem und zweitem Schaltungsträger aufweist.

9. Verfahren zur Herstellung eines elektrischen Bauelementeträgers, bestehend aus folgenden Verfahrensschritten:
Aufteilung einer elektrischen Schaltung auf wenigstens zwei Schaltungsträger, wobei wenigstens ein erster Schaltungsträger vorzugsweise für das Bestücken mit bedrahteten Bauelementen und Sonderbauteilen und ein zweiter Schaltungsträger vorzugsweise ohne bzw. mit geringer Bestückung mit bedrahteten Bauelementen und Sonderbauteilen vorgesehen wird;
Bestücken des ersten Schaltungsträgers und elektrisches Kontaktieren durch Löten;
Befestigen des bzw. der ersten Schaltungsträger an einer Aufnahmerichtung;
Befestigen der Aufnahmeeinrichtung auf dem zweiten Schaltungsträger; und
elektrisches Verbinden des ersten Schaltungsträgers mit dem zweiten Schaltungsträger über wenigstens einen Leiter geringer Steifigkeit und wobei der Leiter mit wenigstens einem Pin, vorzugsweise einem Stanzgitterpin gebildet ist, der eine Geometrie zur mechanischen Entlastung aufweist.

10. Verfahren nach Anspruch 9, **dadurch gekennzeichnet, dass** der erste und/oder zweite Schaltungsträger mit einer auf einem Metallträger auflaminierten Leiterplatte oder Folie gebildet wird.

## Claims

1. Component carrier (10), consisting of
at least one first circuit carrier (11) populated with wired electrical components (20) and special components,
a device (12) for receiving at least one first circuit carrier (11); and of
a second circuit carrier (13), spaced apart from the first circuit carrier, without or with only few wired electrical components and special components,
wherein the second circuit carrier (13) is electrically connected to each first circuit carrier (11) by means of at least one conductive connection (26) having low stiffness, **characterized**
**in that** the conductive connection (26) having low stiffness is formed with at least one pin, preferably a leadframe pin, which has a geometry for mechanical load relief.

2. Component carrier according to Claim 1, **characterized in that** the first and/or the second circuit carrier have/has a printed circuit board, flexible foil or the like.

3. Component carrier according to Claim 1 or 2, **characterized in that** the wired components (20) and the special components are fixed on each first circuit carrier by means of an adhesive (21) and/or a separate holder.

4. Component carrier according to any of the preceding claims, **characterized in that** two first circuit carriers (11) are arranged on the receiving device (12).

5. Component carrier according to any of the preceding claims, **characterized in that** the receiving device (12) is embodied as a frame-shaped or planar mount.

6. Component carrier according to any of the preceding claims, **characterized in that** the receiving device (12) is formed from plastic, casting or sheet metal.

7. Component carrier according to any of the preceding claims, **characterized in that** at least one connection location for the conductive connection (26) is formed on each first circuit carrier (11).

8. Component carrier according to any of the preceding claims, **characterized in that** the conductive connection (26) having geometry for mechanical load relief has a mechanical load-relief section (27) in the region between first and second circuit carriers.

9. Method for producing an electrical component carrier, consisting of the following method steps:
dividing an electrical circuit between at least two circuit carriers, wherein at least one first circuit carrier is preferably provided for population with wired components and special components and a second circuit carrier is preferably provided without or with little population with wired components and special components;
populating the first circuit carrier and making electrical contact by means of soldering;
fixing the first circuit carrier(s) to a receiving device;
fixing the receiving device on the second circuit carrier; and
electrically connecting the first circuit carrier to the second circuit carrier via at least one conductor having low stiffness and wherein the conductor is formed with at least one pin, preferably a leadframe pin, which has a geometry for mechanical load relief.

10. Method according to Claim 9, **characterized in that** the first and/or second circuit carrier are/is formed with a printed circuit board or foil laminated on a metal carrier.

## Revendications

1. Porte-composants (10) constitué de :
au moins un premier porte-circuit (11) équipé de composants électriques (20) câblés et de composants spéciaux,
un dispositif (12) qui loge au moins un premier porte-circuit (11) et
un deuxième porte-circuit (13) situé à distance du premier porte-circuit, sans composants électriques câblés ni composants spéciaux ou avec seulement un petit nombre de ceux-ci,
le deuxième porte-circuit (13) étant raccordé électriquement à chaque premier porte-circuit (11) au moyen d'au moins une liaison conductrice (26) à faible rigidité,
**caractérisé en ce que**
la liaison conductrice (26) à faible rigidité est configurée avec au moins un goujon, de préférence un goujon de grille estampé dont la géométrie permet un délestage mécanique.

2. Porte-composants selon la revendication 1, **caractérisé en ce que** le premier et/ou le deuxième porte-circuit présentent une carte de circuit, une feuille flexible ou similaire.

3. Porte-composants selon les revendications 1 ou 2, **caractérisé en ce que** les composants câblés (20) et les composants spéciaux sont fixés sur le premier porte-circuit au moyen d'un adhésif (21) et/ou d'un support séparé.

4. Porte-composants selon l'une des revendications précédentes, **caractérisé en ce que** deux premiers porte-circuits (11) sont disposés sur le dispositif de réception (12).

5. Porte-composants selon l'une des revendications précédentes, **caractérisé en ce que** le dispositif de réception (12) est configuré en forme d'encadrement ou de support plat.

6. Porte-composants selon l'une des revendications précédentes, **caractérisé en ce que** le dispositif de réception (12) est formé de matière synthétique, de fonte ou de tôle.

7. Porte-composants selon l'une des revendications précédentes, **caractérisé en ce qu'**au moins un emplacement de raccordement pour la liaison conductrice (26) est formé sur chaque premier porte-circuit (11).

8. Porte-composants selon l'une des revendications précédentes, **caractérisé en ce que** la liaison conductrice (26) dont la géométrie permet un délestage mécanique présente une partie mécanique de délestage (27) dans sa partie située entre le premier et le deuxième porte-circuit.

9. Procédé de fabrication d'un porte-composants électrique, le procédé étant constitué des étapes suivantes :
répartition d'un circuit électrique sur au moins deux porte-circuits, au moins un premier porte-circuit étant prévu de préférence pour être équipé de composants câblés et de composants spéciaux et un deuxième porte-circuit étant prévu de préférence sans ou avec peu de composants câblés et de composants spéciaux,
équipement du premier porte-circuit et établissement du contact électrique par brasage,
fixation du ou des premiers porte-circuits sur un dispositif de réception,
fixation du dispositif de réception sur le deuxième porte-circuit et
raccordement électrique du premier porte-circuit et du deuxième porte-circuit par au moins un conducteur à faible rigidité,
le conducteur étant configuré avec au moins un goujon, de préférence un goujon de grille estampée, dont la géométrie permet un délestage mécanique.

10. Procédé selon la revendication 9, **caractérisé en ce que** le premier et/ou le deuxième porte-circuit sont configurés avec une carte de circuit ou une feuille stratifiée sur un support métallique.
